# EUROPÄISCHE PATENTSCHRIFT

(11) **EP 2 698 044 B1**
(45) Veröffentlichungstag und Bekanntmachung des Hinweises auf die Patenterteilung: **19.07.2017**
(21) Anmeldenummer: 12740479.6
(22) Anmeldetag: 10.04.2012
(51) Int. Cl.: H05K 1/02, H05K 3/04

(54) **LEITERBAHNANORDNUNG FÜR EIN KRAFTFAHRZEUG-AUSSTATTUNGSTEIL**
CONDUCTING TRACK ASSEMBLY FOR A MOTOR VEHICLE EQUIPMENT PART
ENSEMBLE PISTE CONDUCTRICE POUR UN ÉLÉMENT D'ÉQUIPEMENT DE VÉHICULE AUTOMOBILE

(30) Priorität: 09.04.2011 DE 102011016603
(43) Veröffentlichungstag der Anmeldung: 19.02.2014
(73) Patentinhaber: Johnson Controls GmbH, 51399 Burscheid (DE)
(72) Erfinder: DOLISY, Jacky, F-57220 Bisten-en-Lorraine (FR)
(74) Vertreter: Liedtke, Markus
(86) Internationale Anmeldenummer: PCT/EP2012/001549
(87) Internationale Veröffentlichungsnummer: WO 2012/171596

(56) Entgegenhaltungen:
- DE-A1- 3 628 981
- JP-A- 2006 156 512
- JP-A- 2006 261 430
- US-A- 3 978 375
- US-B1- 6 194 787

## Beschreibung

Die Erfindung betrifft ein Kraftfahrzeug-Ausstattungsteil mit einer Leiterbahnanordnung und ein Verfahren zur Herstellung eines Kraftfahrzeug-Ausstattungsteils.

### Stand der Technik

Bei der Herstellung von Kraftfahrzeug-Ausstattungsteilen, die elektrische Komponenten tragen, ist es bekannt, die Ausrüstung des Ausstattungsteils mit den dafür erforderlichen Leiterbahnen zu bewerkstelligen, indem ein Stanzteil aus elektrisch leitfähigem Material, etwa aus einer Kupferlegierung oder einem verzinkten Metallblech, dauerhaft mit dem Ausstattungsteil verbunden wird. In dieser Weise werden beispielsweise Baugruppen für Kraftfahrzeug-Rückleuchten hergestellt, bei denen eine als Stanzblech erzeugte Leiterbahnanordnung mit einem aus Kunststoff gefertigten Basisteil verbunden wird, um so einen Glühlampenträger für die Funktionen Fahrlicht, Bremslicht etc. zu erhalten.

Es gibt Ausstattungsteile, bei deren Fertigung Vorteile durch Einsatz einer teilbaren Leiterbahnanordnung erreicht werden können. Aus der deutschen Gebrauchsmusteranmeldung DE 200 09 835 U1 ist eine solche Anordnung bekannt, bei der zwei im Betriebszustand separat voneinander vorgesehene Teile einer Leiterbahnanordnung im Ausgangszustand durch Trennstellen miteinander verbunden sind, wodurch diese Leiterbahnanordnung zunächst einteilig vorliegt und damit während einiger Fertigungsschritte erleichtert handhabbar ist.
Während eines Schrittes der Fertigung einer Kraftfahrzeug-Sonnenblende werden dann diese Trennstellen aktiviert, und somit die Betriebsfähigkeit der Leiterbahnanordung hergestellt, indem die Funktion eines Schaltkontaktes bereitgestellt wird.

Aus der JP2006156512A und JP2006261430 sind alternative reversible Steckbrücken oder Relais-/Schaltkontakte bekannt.

Aus der US 6,194,787 B1, der DE 36 28 981 A1 und US 3,978,375 sind verschiedene Leiterbahnanordnungen bekannt, welche Parallellleitungen für eine Verbindung, abtrennbare Leiterplattenbereiche bzw. Stützverbindungen offenbaren.

### Aufgabe

Der Erfindung liegt die Aufgabe zugrunde, ein gattunsgemässes Kraftfahrzeug-Ausstattungsteil mit einer Leiterbahnanordnung derart fortzubilden, dass weitere Verbesserungen und einhergehend Kostenersparnisse in der Herstellung von Kraftfahrzeug-Ausstattungsteilen ermöglicht werden.

### Lösung

Die Aufgabe wird erfindungsgemäß durch die Merkmale des Anspruchs 1 gelöst, wobei ein Konfigurationsmittel an der teilbaren Leiterbahnanordnung vorgesehen ist, vermittels dessen die Leiterbahnanordnung, und infolgedessen das Kraftfahrzeug-Ausstattungsteil, für den Betrieb in einer Betriebsart des Kraftfahrzeug-Ausstattungsteils aus einer Mehrzahl von Betriebsarten konfigurierbar ist.

Damit wird eine Leiterbahnanordnung angegeben, in der in ihrem Ausgangszustand die Möglichkeit zu verschiedenen Betriebsarten angelegt ist, und die, verbunden mit der Herstellung des Betriebszustands, die Festlegung auf eine Betriebsart durch Anwendung des Konfigurationsmittels ermöglicht.

Damit kann dasselbe Bauteil, nämlich dieselbe teilbare Leiterbahnanordnung, für die Herstellung verschiedener Varianten eines Kraftfahrzeug-Ausstattungsteils herangezogen werden. Die Lagerhaltung wird vereinfacht und es ergeben sich Preisvorteile bei der Beschaffung solcher Leiterbahnanordnungen.

Mit Vorteil beinhaltet das Konfigurationsmittel einen elektrischen Leiter. Es kann sich bei dem Mittel etwa um eine mit Kunststoff ummantelte, metallene Steckbrücke handeln, vergleichbar den im Automobilbau verwendeten Schmelzsicherungen. Bevorzugt enthält das Mittel einen zur übrigen Leiterbahnanordnung materialgleichen Leiter oder besteht gänzlich aus diesem Material.

Eine besonders einfache Variante mit Blick auf die Lagerung der Bauteile im Ausgangszustand ergibt sich, indem das Konfigurationsmittel einstückig mit der Leiterbahnanordnung vorgesehen ist.

Besonders vorteilhaft ist eine Ausführungsform, bei welcher das Konfigurationsmittel als eine odere mehrere Trennstellen der teilbaren Leiterbahnanordnung realisiert ist. So wird es möglich, die Konfiguration der Betriebsart der Leiterbahnanordnung und infolge dessen des Kraftfahrzeug-Ausstattungsteils, ohne wesentlichen Mehraufwand in denselben Fertigungsschritt zu integrieren, in welchem auch die Teilung der Leiterbahnanordnung vorgenommen wird, was üblicherweise kurz vor, während, oder kurz nach dem Verbinden der Leiterbahnanordnung mit dem - in der Regel aus Kunststoff vorgefertigten - Basisteil passiert.
Im Gegensatz zu etwa der Verwendung von Steckbrücken als Konfigurationsmittel liegt in dieser Ausführungsform eine dauerhafte bzw. irreversible Konfiguration begründet, woraus sich jedoch je nach Art des Kraftfahrzeug-Ausstattungsteiles kein Nachteil ergibt.

Je nach Leiterbahnführung in dem Ausstattungsteil, die konstruktions- bzw. fertigungsbedingten Erfordernissen unterliegt, ist in einer Ausführungsform der Erfindung eine das oder einen Teil des Konfigurationsmittels bildende Trennstelle im Zuge der Herstellung des Ausstattungsteils zur Aktivierung bestimmt oder zur Nicht-Aktivierung bestimmt. Bei Nicht-Aktivierung bleibt also auch im Betriebszustand die Verbindung über diese Trennstelle bestehen, welche im Ausgangszustand Teile der Leiterbahnanordnung miteinander verbindet. Die gewünschte Betriebsart bedingt dabei, ob eine Trennstelle aktiviert werden muss oder nicht aktiviert werden darf, um die entsprechende Leiterbahnführung zu erschaffen.

### Figuren

Die Erfindung wird nachfolgend anhand eines Ausführungsbeispiels näher erläutert. Das in den Figuren behandelte Beispiel betrifft eine Sonnenblende als Kraftfahrzeug-Ausstattungsteil, welche mit zwei Lichtquellen in Form von LED versehen ist, die einem in die Sonnenblende integrierten Schminkspiegel zugeordnet sind.

Es sind eine erste Betriebsart und eine zweite Betriebsart als Möglichkeit angelegt, wobei die LED in der ersten Betriebsart in Serie, demgegenüber in der zweiten Betriebsart parallel geschaltet sind.
Die Nummerierung der Bezugszeichen hat für alle Figuren Gültigkeit.

Es zeigen:
- Fig. 1: Explosionsdarstellung Spiegelkassette einer Sonnenblende
- Fig. 2: eine erfindungsgemässe Leiterbahnanordnung im Ausgangszustand
- Fig. 3a: Stromlaufplan und Konfigurationsvorgaben Serienschaltung
- Fig. 3b: Stromlaufplan und Konfigurationsvorgaben Parallelschaltung
- Fig. 4: eine Leiterbahnanordnung im Betriebszustand, in der Betriebsart 'Serienschaltung'
- Fig. 5a: Ausschnittsvergrösserung von Darstellung Fig. 4
- Fig. 5b: Detaildarstellung analog zu Fig 5a, jedoch für die Betriebsart 'Parallelschaltung'

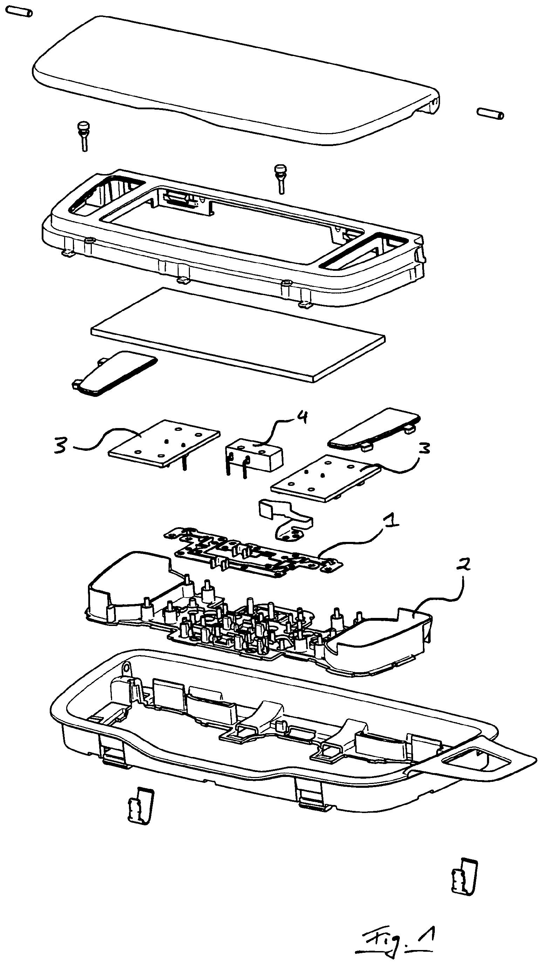

Die Figur 1 dient der Veranschaulichung, in welcher Weise eine erfindungsgemässe Leiterbahnanordnung 1 bei der Herstellung der Sonnenblende verwendet wird. Unterhalb der Leiterbahnanordnung 1 ist ein Basisteil 2 gezeigt, mit welchem sie bei der Herstellung verbunden wird. Dazu sind an dem Basisteil zylinderförmige Erhebungen angeordnet, die mit korrespondierenden Ausnehmungen der Leiterbahnanordnung 1 gefügt, beispielsweise im Wege des Aufpressens daran festgelegt werden.

Weiterhin sind unter anderem die Rahmenteile der Spiegelkassette, Spiegel, Spiegelabdeckung, LED-Trägerplatten 3 sowie der mit der Spiegelabdeckung zusammenwirkende Schalter 4 zum Schalten der Beleuchtung sichtbar.

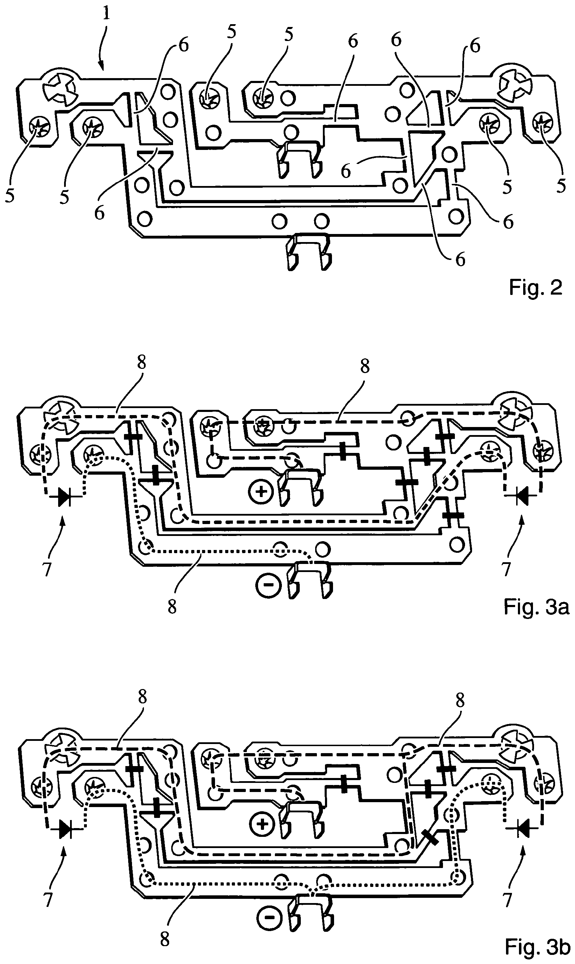

Figur 2 zeigt eine als Stanzteil ausgeführte Leiterbahnanordnung im Ausgangszustand. Es sind Einpressausnehmungen 5 für die Kontaktierung des Schalters 4 bzw von LEDs vorbereitet. Alle vorgesehenen Trennstellen 6 sind nicht aktiviert. Weil die Trennstellen somit die Teile der Leiterbahnanordung 1 mechanisch miteinander verbinden, liegt die Anordnung einteilig vor und ihre Handhabung ist erleichtert.

Die Figur 3a ist eine Schemadarstellung für eine der Beschaltungsarten der Schminkspiegel-Beleuchtung, die als Möglichkeit in dem Stanzteil angelegt wurden, nämlich die Serienschaltung zweier in die Sonnenblende integrierter LED 7. Unregelmässige Linien 8 zeigen den Verlauf des dafür erforderlichen Strompfades. Diejenigen aus der Gesamtheit der Trennstellen 6, welche für diese Betriebsart aktiviert werden müssen, um die Betriebsbereitschaft der Leiterbahnanordnung zu bewirken, sind schematisch mit kleinen Querbalkensymbolen gekennzeichnet. Für eine bessere Übersicht wurden die Bezugszeichen der Trennstellen 6 in den Figuren 3a, 3b weggelassen; die Trennstellen sind stets lagegleich zur Figur 2.

Figur 3b ist eine demselben Prinzip folgende Schemadarstellung, jedoch für die andere mögliche Betriebsart, bei der die LED 7 in Parallelschaltung betrieben werden.

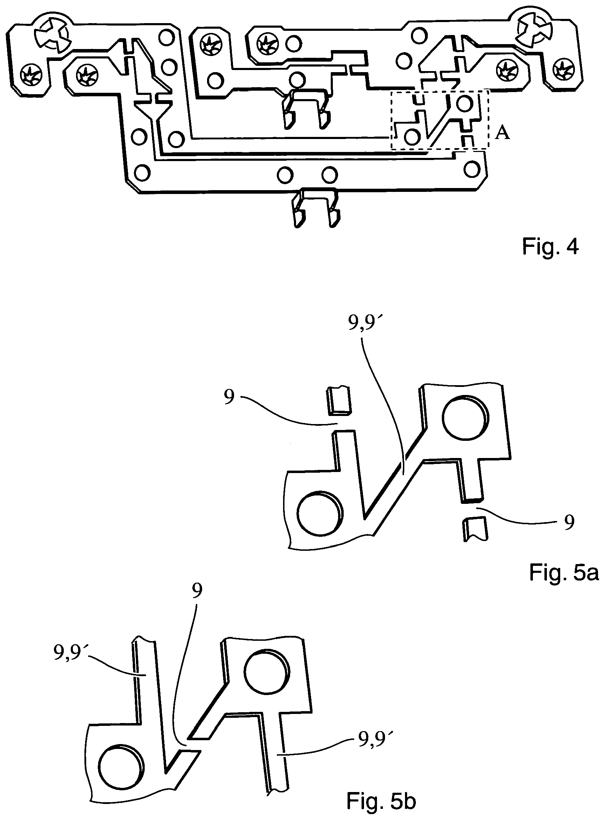

In Figur 4 ist die Leiterbahnanordnung im Betriebszustand gezeigt, für die Betriebsart 'Seriell'. Die isolierte Darstellung der Anordung dient hier der besseren Erkennbarkeit der erfindungswesentlichen Aspekte. In Wirklichkeit ist die Anordnung im Betriebszustand bereits mit dem Basisteil 2 verbunden und die Kontakte zu LEDs bzw. Schalter (hier nicht gezeigt) sind hergestellt. Die Trennstellen 6 sind betriebsartbezogen aktiviert, d.h. entsprechende Unterbrechungen sind also in dieser Figur sichtbar.

Mit einem Strichlinienrahmen ist eine Einzelheit A der Leiterbahnanodnung in der Figur 4 markiert, die in den nachfolgenden Figuren 5a bzw. 5b nochmals vergrössert wiedergegeben ist.
Es handelt sich bei den Figuren 5a und 5b um Darstellungen, aus denen das Konfigurationsmittel unmittelbar erkennbar wird. Gemäss dem hier vorliegenden Ausführungsbeispiel ist es als eine Gruppe von Trennstellen 6 realisiert, bestehend aus den drei Trennstellen 9.

Im unmittelbaren Vergleich zwischen Fig. 5a und Fig. 5b ist deutlich sichtbar, dass unabhängig von der konfigurierten Betriebsart stets über eine oder mehrere nicht aktivierte Trennstellen 9' eine elektrisch leitende Verbindung besteht, wobei die Konfigurationswirkung in dem hier erläuterten Beispiel das Zusammenwirken von aktivierten und nicht aktivierten Trennstellen zwingend erfordert.

### Bezugszeichenliste

- 1: Leiterbahnanordnung
- 2: Basisteil
- 3: LED-Trägerplatte
- 4: Schalter
- 5: Einpressausnehmung
- 6: Trennstelle der Leiterbahnanordnung
- 7: LED
- 8: Strom pfad
- 9, 9': Trennstelle des Konfigurationsmittels

## Patentansprüche

1. Sonnenblende als Kraftfahrzeug-Ausstattungsteil mit einer teilbaren Leiterbahnanordnung (1), die
- einteilig ausgebildet ist und
- eine oder mehrere Trennstellen (6) aufweist, über welche Teile der Leiterbahnanordnung (1) im Ausgangszustand miteinander verbunden und nicht aktiviert sind, wobei
- ein Konfigurationsmittel an der Leiterbahnanordnung (1) vorgesehen ist, vermittels dessen sie für den Betrieb in einer Betriebsart der Sonnenblende aus einer Mehrzahl von Betriebsarten durch Trennung einer oder mehrerer Trennstellen (6) im Betriebszustand irreversibel konfiguriert und aktiviert ist, und
- mindestens eine oder mehrere elektrisch leitende Verbindungen von Teilen der Leiterbahnanordnung (1) über eine oder mehrere nicht aktivierte Trennstellen (9, 9') bestehen bleibt bzw. bleiben.

2. Sonnenblende nach Anspruch 1, **dadurch gekennzeichnet, dass** das Konfigurationsmittel einen elektrischen Leiter beinhaltet.

3. Sonnenblende nach Anspruch 1 oder 2, **dadurch gekennzeichnet, dass** das Konfigurationsmittel materialgleich zur Leiterbahnanordnung (1) ausgeführt ist.

4. Sonnenblende nach einem der Ansprüche 1 bis 3, **dadurch gekennzeichnet, dass** das Konfigurationsmittel einstückig mit der Leiterbahnanordnung (1) vorgesehen ist.

5. Sonnenblende nach einem der vorherigen Ansprüche, **dadurch gekennzeichnet, dass** das Konfigurationsmittel als Trennstelle (9) oder Mehrzahl von Trennstellen (9) ausgebildet ist.

6. Sonnenblende nach Anspruch 5, **dadurch gekennzeichnet, dass** Teile der Leiterbahnanordnung im Betriebszustand über zumindest eine Trennstelle (9') elektrisch leitend miteinander verbunden sind.

7. Sonnenblende nach einem der vorhergehenden Ansprüche, wobei die Leiterbahnanordnung (1) zwei Lichtquellen jeweils in Form einer LED (7) umfasst, die im Betriebszustand in zwei Betriebsarten entweder in Serienschaltung oder Parallelschaltung betrieben werden können, wobei aus der Gesamtheit der im Ausgangszustand nicht aktivierten Trennstellen (6) eine oder mehrere Trennstelle/n (6) betriebsartbezogen aktivierbar ist bzw. sind, wodurch die LEDs in einer ersten Betriebsart in Serie oder in einer zweiten Betriebsart parallel schaltbar sind.

8. Herstellungsverfahren für eine Sonnenblende als Kraftfahrzeug-Ausstattungsteil nach einem der Ansprüche 1 bis 7, mit einer teilbaren Leiterbahnanordnung (1), welches einen Verfahrensschritt beinhaltet, in dem die Leiterbahnanordnung, von einem Ausgangszustand der Leiterbahnanordnung (1) ausgehend, unter Einsatz des Konfigurationsmittels für den Betrieb in einer Betriebsart des Kraftfahrzeug-Ausstattungsteils aus einer Mehrzahl von Betriebsarten durch Trennung einer oder mehrerer Trennstellen (6) irreversibel konfiguriert und aktiviert und damit in die eine Betriebsart überführt wird.

## Claims

1. Sun visor as a motor vehicle equipment part, comprising a divisible conductor track arrangement (1) which
- is of integral design and
- has one or more separating points (6) by means of which parts of the conductor track arrangement (1) are connected to one another and not activated in the starting state, wherein
- a configuration means is provided on the conductor track arrangement (1), by means of which configuration means the conductor track arrangement is irreversibly configured and activated for operation in one mode of operation of the sun visor from amongst a plurality of modes of operation by separating one or more separating points (6) in the operating state, and
- at least one or more electrically conductive connections of parts of the conductor track arrangement (1) remains or remain by means of one or more separating points (9, 9') which are not activated.

2. Sun visor according to Claim 1, **characterized in that** the configuration means contains an electrical conductor.

3. Sun visor according to Claim 1 or 2, **characterized in that** the configuration means is constructed from the same material as the conductor track arrangement (1).

4. Sun visor according to one of Claims 1 to 3, **characterized in that** the configuration means is integrally provided with the conductor track arrangement (1).

5. Sun visor according to one of the preceding claims, **characterized in that** the configuration means is in the form of a separating point (9) or a plurality of separating points (9).

6. Sun visor according to Claim 5, **characterized in that** parts of the conductor track arrangement are electrically conductively connected to one another by means of at least one separating point (9') in the operating state.

7. Sun visor according to one of the preceding claims, wherein the conductor track arrangement (1) comprises two light sources, each in the form of an LED (7), which can be operated either in series or in parallel in two modes of operation in the operating state, wherein one or more separating point/points (6) from amongst all of the separating points (6) which are not activated in the starting state is or are activatable depending on the mode of operation, as a result of which the LEDs are connectable in series in a first mode of operation or are connectable in parallel in a second mode of operation.

8. Production method for a sun visor as a motor vehicle equipment part according to one of Claims 1 to 7 comprising a divisible conductor track arrangement (1), which production method contains a method step in which the conductor track arrangement, starting from a starting state of the conductor track arrangement (1), is irreversibly configured and activated for operation in one mode of operation of the motor vehicle equipment part from amongst a plurality of modes of operation using the configuration means by separating one or more separating points (6), and is therefore switched to the said mode of operation.

## Revendications

1. Pare-soleil destiné à servir de pièce d'équipement pour véhicule à moteur, avec un dispositif divisible à pistes conductrices (1), lequel
- est conçu d'une seule pièce ; et
- présente un ou plusieurs points de séparation (6), par l'intermédiaire desquels des parties du dispositif à pistes conductrices (1) sont raccordées les unes aux autres à l'état de sortie et ne sont pas activées, selon lequel :
- un moyen de configuration est prévu au niveau du dispositif à pistes conductrices (1), au moyen duquel ce dernier est activé et configuré de manière irréversible par la séparation d'un ou de plusieurs points de séparation (6), à l'état de fonctionnement, pour une utilisation dans un mode de fonctionnement du pare-soleil parmi une pluralité de modes de fonctionnement ; et
- au moins une ou plusieurs connexions électriquement conductrices de parties du dispositif à pistes conductrices (1) demeure ou demeurent en place par l'intermédiaire d'un ou de plusieurs points de séparation (9, 9') non activés.

2. Pare-soleil selon la revendication 1, **caractérisé en ce que** le moyen de configuration inclut un conducteur électrique.

3. Pare-soleil selon la revendication 1 ou 2, **caractérisé en ce que** le moyen de configuration est fabriqué dans le même matériau que le dispositif à pistes conductrices (1).

4. Pare-soleil selon l'une des revendications 1 à 3, **caractérisé en ce que** le moyen de configuration est prévu pour être formé d'une seule pièce avec le dispositif à pistes conductrices (1).

5. Pare-soleil selon l'une des revendications susmentionnées, **caractérisé en ce que** le moyen de configuration est conçu sous la forme d'un point de séparation (9) ou d'une pluralité de points de séparation (9).

6. Pare-soleil selon la revendication 5, **caractérisé en ce que** des parties du dispositif à pistes conductrices sont raccordées les unes aux autres de manière électriquement conductrice à l'état de fonctionnement, par l'intermédiaire de tout au moins un point de séparation (9').

7. Pare-soleil selon l'une des revendications précédentes, selon lequel le dispositif à pistes conductrices (1) comprend deux sources de lumière, respectivement sous la forme d'une diode électroluminescente (DEL) (7), qui, à l'état de fonctionnement, peuvent être exploitées en deux modes de fonctionnement, c'est à dire soit dans un circuit monté en série, soit dans un circuit monté en parallèle, selon lequel un ou plusieurs point(s) de séparation (6) peut ou peuvent être activé(s), en fonction du mode de fonctionnement sélectionné, parmi la totalité des points de séparation (6) non activés à l'état de sortie, permettant ainsi de pouvoir commuter les DEL en série dans un premier mode de fonctionnement ou de pouvoir les commuter en parallèle dans un deuxième mode de fonctionnement.

8. Procédé de fabrication pour un pare-soleil destiné à servir de pièce d'équipement pour véhicule à moteur selon l'une des revendications 1 à 7, avec un dispositif divisible à pistes conductrices (1), lequel inclut une phase de procédé, dans laquelle le dispositif à pistes conductrices (1), à partir d'un état de sortie du dispositif à pistes conductrices (1), est activé et configuré de manière irréversible par la séparation d'un ou de plusieurs points de séparation (6), ce en recourant au moyen de configuration pour une utilisation dans un mode de fonctionnement de la pièce d'équipement du véhicule à moteur parmi une pluralité de modes de fonctionnement, et est par conséquent transféré dans l'un de ces modes de fonctionnement.
